# EUROPÄISCHE PATENTSCHRIFT

(11) **EP 4 037 972 B1**
(45) Veröffentlichungstag und Bekanntmachung des Hinweises auf die Patenterteilung: **22.11.2023**
(21) Anmeldenummer: 20793244.3
(22) Anmeldetag: 17.09.2020
(51) Int. Cl.: B64F 1/34, B64F 1/36, B60L 15/00, B60L 53/31, H02M 5/458, H02M 7/08, H02M 7/493, H02M 7/00, H05K 7/14

(54) **BODENSTROMAGGREGAT FÜR DAS BEREITSTELLEN VON ELEKTRISCHER ENERGIE FÜR FLUGGERÄTE**
GROUND POWER AGGREGATE FOR PROVIDING ELECTRICAL ENERGY TO AIRCRAFT ON-BOARD COMPONENTS
GROUPE ÉLECTRIQUE AU SOL POUR FOURNIR DE L'ÉNERGIE ÉLECTRIQUE À DES COMPOSANTS À BORD D'UN AVION

(30) Priorität: 02.10.2019 AT 508352019
(43) Veröffentlichungstag der Anmeldung: 10.08.2022
(73) Patentinhaber: Dynell GmbH, 4613 Mistelbach bei Wels (AT)
(72) Erfinder: GRABNER, Herbert, 4613 Mistelbach bei Wels (AT); MOSER, Philipp, 4613 Mistelbach bei Wels (AT); RASCHKO, Christian, 4613 Mistelbach bei Wels (AT)
(74) Vertreter: Burger, Hannes
(86) Internationale Anmeldenummer: PCT/AT2020/060338
(87) Internationale Veröffentlichungsnummer: WO 2021/062455

(56) Entgegenhaltungen:
- EP-A1- 0 134 554
- EP-A1- 3 065 260
- EP-A2- 2 399 769
- WO-A2-2005/124990
- DE-A1- 3 423 867
- DE-A1- 10 043 747
- US-A1- 2013 322 016

## Beschreibung

Die Erfindung betrifft ein Bodenstromaggregat für das Bereitstellen von elektrischer Energie für Fluggeräte und ein Verfahren zum Warten und Betreiben des erfindungsgemäßen Bodenstromaggregates.

Gemäß dem Stand der Technik werden die Funktionen eines Bodenstromaggregates elektronisch und baulich in einer Gesamteinheit realisiert. Dabei sind sämtliche leistungselektronischen Komponenten in einem Schaltschrank verbaut. Dies bringt den Nachteil, dass die Komponenten nur mit hohem Zeitaufwand und unter Einsatz von Spezialwerkzeug, wechselbar sind. Zudem geht ein Wechselvorgang in der Regel mit einem hohen Kostenaufwand einher. Aus der EP 2212203 A1 ist ein Bodenunterstützungsgerätewagen bekannt, welcher ein oder mehrere rechteckige Gerätemodule umfasst, die abnehmbar auf dem Wagen angebracht sind, wobei wenigstens eines oder mehrere der abnehmbaren Module elektrische Leistungsumwandlungskomponenten enthalten, Der Wagen umfasst ferner ein erstes rechteckiges Modul, das Flugzeug-Klimatisierungskomponenten, die auf dem Wagen angebracht sind, enthält und sich über die Breite des Wagens erstreckt, aber im Wesentlichen weniger als die Hälfte der Länge des Wagens einnimmt, und ein zweites rechteckiges Modul, das Leistungsumwandlungskomponenten, die auf dem Wagen angebracht sind, enthält und im Wesentlichen den Rest des Wagens einnimmt.

DE 34 23 867 A1 offenbart eine selbstfahrende Bordnetzversorgungsanlage für Flugzeuge mit einem Lastkraftfahrzeug und einem dieselbetriebenen Wechselspannungsgenerator. Das Fahrzeug wird von dem Generator mittels eines Gleichstrommotors über einen Gleichrichter gespeist.

Die WO 2018005451 A1 offenbart ein integriertes mobiles Bodenunterstützungssystem, welches einen mit Rädern versehenen Wagen umfasst, auf dem ein Kraftwerk montiert ist, um einen Luftkompressor anzutreiben, um einem Flugzeug Zapfluft zuzuführen. Das Kraftwerk treibt auch einen elektrischen Generator an, dessen Leistung gesteuert und in Wechsel- und/oder Gleichstrom umgewandelt wird, um den Leistungsbedarf des Flugzeugs zu decken. Eine Klimatisierungseinheit ist ebenfalls an dem Wagen angebracht, um dem Flugzeug klimatisierte Luft zuzuführen.

Aufgabe der vorliegenden Erfindung war es, die Nachteile des Standes der Technik zu überwinden und eine Vorrichtung und ein Verfahren zur Verfügung zu stellen, welche eine einfache Wartung eines Bodenstromaggregates ermöglichen.

Diese Aufgabe wird durch eine Vorrichtung und ein Verfahren gemäß den Ansprüchen gelöst.

Die Erfindung betrifft ein Bodenstromaggregat für das Bereitstellen von elektrischer Energie für Fluggeräte, das Bodenstromaggregat umfassend:
- ein Grundgestell;
- ein Kabelsystem, welches im Grundgestell ausgebildet ist;
- zumindest ein Gleichrichtermodul zum Umwandeln einer an einer Gleichrichtermoduleingangsseite anliegenden Eingangswechselspannung in eine an einer Gleichrichtermodulausgangsseite abgehende Zwischengleichspannung, wobei die Gleichrichtermodulausgangsseite mit einem Zwischenkreisleiter gekoppelt ist;
- zumindest ein Wechselrichtermodul zum Umwandeln der an einer Wechselrichtermoduleingangsseite anliegenden Zwischengleichspannung in eine an einer Wechselrichtermodulausgangsseite abgehende Ausgangswechselspannung, wobei die die Wechselrichtermoduleingangsseite mit einem Zwischenkreisleiter gekoppelt ist. Des Weiteren sind das Gleichrichtermodul und das Wechselrichtermodul jeweils als baulich eigenständig ausgebildete Einheiten realisiert, welche einzeln und unabhängig vom Grundgestell wechselbar sind.

Ein derart ausgebildetes Bodenstromaggregat ermöglicht einem Benutzer auf vorteilhafte Art und Weise, einzelne Gleichrichtermodule und Wechselrichtermodule im Vergleich zu bekannten Ausführungen einfach, schnell und wirtschaftlich zu Wechseln. Dies kann insbesondere dann erforderlich sein, wenn einzelne Module defekt sind. Die bauliche Trennung der Module resultiert in Einheiten geringeren Gewichts und kleinerer Außenabmessungen, was das Wechseln zusätzlich erleichtert. Des Weiteren ist es vorteilhaft, dass ausschließlich die defekten Komponenten getauscht werden können. Dadurch wird ein umwelt- und ressourcenschonendes Bodenstromaggregat zur Verfügung gestellt. Zusätzlich sind die Module vergleichsweise preisgünstig herstellbar.

Des Weiteren kann es zweckmäßig sein, wenn das Gleichrichtermodul und das Wechselrichtermodul baugleich ausgeführt sind, insbesondere, wenn das Gleichrichtermodul und das Wechselrichtermodul in elektrischer Flussrichtung gesehen gespiegelt mit dem Kabelsystem gekoppelt sind. Die baugleichen Module unterscheiden sich dabei lediglich in der Ansteuerungssoftware. Diese Ausführungsform ist insofern besonders vorteilhaft, als baugleiche Komponenten preisgünstiger in der Herstellung sind und somit dem Benutzer einen Kostenvorteil ermöglichen. Zudem ist eine geringere Anzahl an Ersatzteilen erforderlich und daraus resultierend eine einfachere Ersatzteillagerhaltung möglich. Dadurch wird gewährleistet, dass im Fall defekter Module, Ersatzmodule rasch verfügbar sind.

Ferner kann vorgesehen sein, dass das Gleichrichtermodul und das Wechselrichtermodul jeweils zumindest einen Stecker aufweisen, welcher jeweils mit einem mit dem Kabelsystem elektrisch leitend verbundenen Gegenstecker gekoppelt ist. Steckverbindungen ermöglichen auf vorteilhafte Art und Weise eine einfach und insbesondere werkzeuglos lös- bzw. herstellbare Verbindung. In der Regel sind für derartige Verbindungsmechanismen die Anforderungen an das Ausbildungs- und Erfahrungslevel des Wartungspersonal gering. So können auch nicht routinierte Benutzer nach einer wenig umfangreichen Einschulungsphase entsprechende Wartungsarbeiten durchführen.

Darüber hinaus kann vorgesehen sein, dass der Stecker derart am Gleichrichtermodul und/oder am Wechselrichtermodul angeordnet ist und der Gegenstecker derart im Bereich einer Aufnahmeaussparung am Grundgestell angeordnet sind, dass in einer Betriebsposition des Gleichrichtermoduls und/oder des Wechselrichtermoduls eine elektrisch leitende Verbindung zwischen dem Stecker und dem Gegenstecker hergestellt ist. Damit kann ohne zusätzlichen Aufwand bzw. ohne einen zusätzlichen Arbeitsschritt eine elektrisch leitende Verbindung hergestellt werden. Des Weiteren wird beim Überführen des Moduls von der Betriebsposition in eine Wechselposition die elektrisch leitende Verbindung automatisch getrennt. Dies trägt maßgeblich zur Sicherheit für den Benutzer bei, da die Gefahr von Stromschlägen reduziert wird. Des Weiteren stellen die Benutzung bzw. die Wartung des erfindungsgemäßen Bodenstromaggregats, wie schon zuvor erwähnt, nur geringe Anforderungen an das Ausbildungs- und Erfahrungslevel des Wartungspersonals.

Vorteilhaft ist auch eine Ausprägung, gemäß welcher vorgesehen sein kann, dass das Gleichrichtermodul und das Wechselrichtermodul einen Schnellverschluss aufweisen, welcher derart ausgebildet ist, dass dieser beim Überführen in die Betriebsposition in einem Schnellverschlussgegenelement im Grundgestell einrastet und/oder automatisch verriegelt. Durch das Vorsehen einer derartigen Verschlussanordnung wird die Möglichkeit geschaffen, eine automatische und auch werkzeuglos herstellbare Verbindung zwischen den Modulen und dem Grundgestell herzustellen. Zudem trägt diese Ausprägung zur Erhöhung der Benutzersicherheit beim Wechselvorgang bei, da durch das automatische einrasten bzw. verriegeln ein unerwünschtes Lösen bzw. Herausfallen der Module weitgehend unterbunden wird.

Gemäß einer Weiterbildung ist es möglich, dass das Gleichrichtermodul und das Wechselrichtermodul auf einer Höhe von 0,5 m bis 2,0 m, besonders bevorzugt auf einer Höhe von 0,6 - 1,8 m, bezugnehmend auf eine Bodenaufstandsfläche des Grundgestells positioniert sind. So wird eine für den Benutzer ergonomische Arbeitshöhe für den Wechselvorgang bereitgestellt. Diese Weiterbildung wirkt sich somit vorteilhaft auf die Dauer des Arbeitsganges aus und erhöht zugleich Komfort und Sicherheit für den Benutzer.

Ferner kann es zweckmäßig sein, wenn das Gleichrichtermodul und das Wechselrichtermodul jeweils auf nur einer Leiterplatte aufgebaut sind. Diese Ausprägung bietet den Vorteil einer kompakten Bauform und einer kostengünstig durchführbaren Serienfertigung.

Gemäß Anspruch 1 ist vorgesehen, dass zumindest zwei Gleichrichtermodule ausgebildet sind, welche elektrisch parallel zueinander geschalten sind und/oder dass zumindest zwei Wechselrichtermodule ausgebildet sind, welche elektrisch parallel zueinander geschalten sind. Durch den Umstand, dass hierdurch dieselben Funktionen parallel ausgeführt werden können ergibt sich eine überaus vorteilhafte Redundanzwirkung. In weiterer Folge bewirkt diese Ausgestaltung gleichermaßen eine Flexibilisierung der Einsatzmöglichkeiten und eine Erhöhung der Anlagenverfügbarkeit.

Des Weiteren ist gemäß Anspruch 1 vorgesehen, dass ein Lastaufteilungssystem ausgebildet ist, welches derart konfiguriert ist, dass eine Lastaufteilung zwischen den Gleichrichtermodulen und/oder zwischen den Wechselrichtermodulen automatisiert erfolgen kann. So kann das System flexibel auf Lastanforderungen reagieren. Dabei kann das Lastaufteilungssystem als Teil eines Zentralrechners ausgestaltet sein.

Insbesondere kann es vorteilhaft sein, wenn eines von mehreren parallel zueinander geschalteten Gleichrichtermodulen und/oder eines von mehreren parallel zueinander geschalteten Wechselrichtermodulen im Teillastbereich wegschaltbar ist. Dadurch können die Wirkungsgrade in diesen Lastpunkten auf vorteilhafte Art und Weise gesteigert werden. Das Wegschalten kann beispielsweise automatisch durch das Lastaufteilungssystem bzw. den Zentralrechner erfolgen, oder auch von einem Benutzer aktiv initialisiert werden.

Gemäß einer besonderen Ausprägung ist es möglich, dass das Gleichrichtermodul und/oder das Wechselrichtermodul eine Datenschnittstelle aufweisen, welche zum Informationsaustausch untereinander, also zwischen den Modulen, und/oder mit einem Zentralrechner ausgebildet ist. Diese Ausprägung gewährleistet ein erhöhtes Maß an Flexibilität für den Benutzer und erhöht das Anwendungsspektrum des Bodenstromaggregats auf vorteilhafte Art und Weise.

Entsprechend einer vorteilhaften Weiterbildung kann vorgesehen sein, dass es sich bei der Datenschnittstelle um eine digitale Datenschnittstelle handelt, und dass dem Gleichrichtermodul und dem Wechselrichtermodul jeweils eine Adresse zugeordnet ist oder zugeordnet werden kann, wobei das zumindest eine Gleichrichtermodul und das zumindest eine Wechselrichtermodul die Adresse bevorzugt über den Stecker erhält. Digitale Schnittstellen bieten allgemein den Vorteil eines flexiblen Datenaustausches. Zudem ist es von Vorteil, wenn die erforderlichen Adressen automatisch über die Steckverbindung zugeordnet werden und somit keine weiteren Verbindungen geschaffen werden müssen. Dies trägt demnach zur Verringerung der baulichen Komplexität bei.

Ferner kann vorgesehen sein, dass der Zwischenkreisleiter mit einem Paralleleingang gekoppelt ist, mittels welchem zusätzliche Gleichstromenergiequellen, wie etwa Batterien oder Ackus, in den Zwischenkreisleiter einbindbar sind. Durch das Vorsehen dieser Weiterbildung werden die Einsatzmöglichkeiten des Bodenstromaggregates vorteilhaft erweitert bzw. flexibilisiert. Des Weiteren können hierdurch hybride Bodenstromversorgungen, auf einfache Art und Weise realisiert werden. Alternativ oder zusätzlich zur Netzspannung bzw. Eingangswechselspannung am Gleichrichtermodul kann eine Energieversorgung über die Zwischenkreisschnittstelle erfolgen. Bevorzugt kommen hierzu Batteriespeicher, Wasserstoffbrennzellen und Dieselaggregate zum Einsatz. Insgesamt kann diese Weiterbildung dazu eingesetzt werden, die Spitzennetzlasten zu reduzieren. Des Weiteren ist es auch möglich, das Bodenstromaggregat unabhängig von einem Netzanschluss zu betreiben. Hierdurch wird das Einsatzspektrum des erfindungsgemäßen Bodenstromaggregats zusätzlich erhöht bzw. flexibilisiert.

Darüber hinaus kann vorgesehen sein, dass eine Entladevorrichtung ausgebildet und derart im Grundgestell und/oder im Gleichrichtermodul und/oder im Wechselrichtermodul angeordnet ist, dass beim Überführen von der Betriebsposition in eine Wechselposition die im Gleichrichtermodul und/oder die im Wechselrichtermodul gespeicherte elektrische Energie automatisch entladen wird. Insbesondere können hierbei Entladewiderstände über Relais oder Halbleiter zugeschaltet werden. Durch diese Ausprägung kann das Sicherheitslevel für den Benutzer während des Wechselvorganges erhöht werden, da das Risiko von Stromschlägen vermindert wird.

Vorteilhaft ist auch ein Verfahren zum Warten und Betreiben eines Bodenstromaggregates für das Bereitstellen von elektrischer Energie für Fluggeräte, insbesondere eines Bodenstromaggregates nach den zuvor erläuterten Ausprägungen. Das Bodenstromaggregat umfasst:
- ein Grundgestell;
- ein Kabelsystem, welches im Grundgestell ausgebildet ist;
- zumindest ein Gleichrichtermodul zum Umwandeln einer an einer Gleichrichtermoduleingangsseite anliegenden Eingangswechselspannung in eine an einer Gleichrichtermodulausgangsseite abgehende Zwischengleichspannung, wobei die Gleichrichtermodulausgangsseite mit einem Zwischenkreisleiter gekoppelt ist;
- zumindest ein Wechselrichtermodul zum Umwandeln der an einer Wechselrichtermoduleingangsseite anliegenden Zwischengleichspannung in eine an einer Wechselrichtermodulausgangsseite abgehende Ausgangswechselspannung, wobei die die Wechselrichtermoduleingangsseite mit einem Zwischenkreisleiter gekoppelt ist. Bei diesem Verfahren ist weiters ein Auswechseln des Gleichrichtermodules und/oder des Wechselrichtermodules vorgesehen, wobei diese jeweils als baulich eigenständig ausgebildete Einheiten realisiert sind, welche einzeln und unabhängig vom Grundgestell ausgewechselt werden.

Ein derart ausgebildetes Verfahren ermöglicht einem Benutzer auf vorteilhafte Art und Weise, einzelne Gleichrichtermodule und Wechselrichtermodule im Vergleich zu bekannten Ausführungen einfach, schnell und wirtschaftlich zu Wechseln. Dies kann insbesondere dann erforderlich sein, wenn einzelne Module defekt sind. Die bauliche Trennung der Module resultiert in Einheiten geringeren Gewichts und kleinerer Außenabmessungen, was das Wechseln zusätzlich erleichtert. Des Weiteren ist es vorteilhaft, dass ausschließlich die defekten Komponenten getauscht werden können. Dadurch wird ein umwelt- und ressourcenschonendes Bodenstromaggregat zur Verfügung gestellt. Zusätzlich sind die Module vergleichsweise preisgünstig herstellbar.

Gemäß Anspruch 13 ist das Gleichrichtermodul und/oder das Wechselrichtermodul mit einem Zentralrechner gekoppelt, wobei der Zentralrechner ein defektes Gleichrichtermodul und/oder Wechselrichtermodul wegschaltet und die Lastverteilung auf die restlichen Gleichrichtermodule und/oder Wechselrichtermodule anpasst. Bevorzugt wird die Lastverteilung über das Lastaufteilungssystem durchgeführt. Diese Weiterbildung ist insofern vorteilhaft, als ein Ausfall eines Modules, beispielsweise infolge eines Defektes, vom Zentralrechner erkannt wird und dieser Ausfall durch ein automatisches Verteilen der Gesamtlast auf die verbleibende Anzahl an Modulen kompensiert wird. Somit wird die Anlagenverfügbarkeit erhöht und die Wirtschaftlichkeit des Betriebs verbessert.

Des Weiteren ist es vorteilhaft, wenn zumindest eines von mehreren parallel zueinander geschalteten Gleichrichtermodulen und/oder zumindest eines von mehreren parallel zueinander geschalteten Wechselrichtermodulen im Teillastbereich weggeschalten wird. Dadurch können die Wirkungsgrade in diesen Lastpunkten auf vorteilhafte Art und Weise gesteigert werden. Das Wegschalten kann beispielsweise automatisch durch das Lastaufteilungssystem bzw. den Zentralrechner erfolgen, oder auch von einem Benutzer aktiv initialisiert werden.

Ein Kabelsystem im Sinne dieses Dokumentes kann elektrische Verbindungen in Form von Leiterplatten und/oder Kabelbäumen umfassen.

Zudem kann vorgesehen sein, dass mehrere der Gleichrichtermodule in horizontaler Richtung nebeneinander angeordnet sind, bzw. dass mehrere der Wechselrichtermodule in horizontaler Richtung nebeneinander angeordnet sind. Weiters kann vorgesehen sein, dass die Gleichrichtermodule und die Wechselrichtermodule in vertikaler Richtung übereinander angeordnet sind. Des Weiteren kann es von Vorteil sein, wenn in einer Ebene mehrere Gleichrichtermodule und Wechselrichtermodule nebeneinander angeordnet sind. Diese Maßnahmen vereinfachen das Auswechseln der Module und verbessert zudem die Luftführung zur Kühlung.

Vorteilhafterweise kann vorgesehen sein, dass die Gleichrichtermodule und Wechselrichtermodule auf Leiterplatten aus Halbleitern aufgebaut sind, wobei die Halbleiter Siliziumkarbid umfassen.

Von Vorteil ist es auch, wenn die Gleichrichtermodule mit einem aktiven Leistungsfaktorkorrekturfilter ausgestattet sind.

Insbesondere kann es zweckmäßig sein, wenn die Gleichrichtermodule und Wechselrichtermodule dazu ausgebildet sind, eine dreiphasige Eingangswechselspannung in eine dreiphasige Ausgangswechselspannung umzuwandeln. Diese Eingangswechselspannung kann in Amplitude und Frequenz variabel sein. Bevorzugt wird eine dreiphasige Eingangswechselspannung von 3x400 V / 50 Hz, 3x480 V / 60 Hz, 960 V / 50 Hz oder 690 V / 50 Hz in eine dreiphasige Ausgangswechselspannung von 3x200 V / 400 Hz umgewandelt. Das Wechselrichtermodul liefert in diesem Fall typischerweise eine Ausgangsspannung, welche höher ist, als die Eingangsspannung. Bevorzugt wird ein Ausgangstransformator zur Spannungsanpassung nachgeschalten. Natürlich ist es auch denkbar, dass an jedem Wechselrichtermodul jeweils ein Ausgangstransformator angeordnet ist. Des Weiteren ist es denkbar, dass die dreiphasige Eingangswechselspannung von 3x400 V / 50 Hz, 3x480 V / 60 Hz, 960 V / 50 Hz oder 690 V / 50 Hz in eine Ausgangsgleichspannung von 28 V DC oder 270 V DC umgewandelt wird. Hierzu wird die Eingangswechselspannung mit den Gleichrichtermodulen gleichgerichtet. Die daraus erzeugte Gleichspannung dient in weiterer Folge als Eingangsspannung für einen Gleichspannungswandler. Das Wechselrichtermodul kann dabei als Teil des Gleichspannungswandlers ausgebildet sein, oder kann auch die gesamte Funktion des Gleichspannungswandlers übernehmen.

Zum besseren Verständnis der Erfindung wird diese anhand der nachfolgenden Figuren näher erläutert.

Es zeigen jeweils in stark vereinfachter, schematischer Darstellung:
- Fig. 1: eine isometrische Ansicht einer Ausführungsform des Bodenstromaggregates mit geöffneter Schutzabdeckung;
- Fig. 2: eine isometrische Ansicht zweier Gleichrichtermodule und/oder Wechselrichtermodule;
- Fig. 3: ein erstes Blockschema einer möglichen Anordnung von je einem Gleichrichtermodul und je einem Wechselrichtermodul in einem Bodenstromaggregat;
- Fig. 4: ein zweites Blockschema einer weiteren möglichen Anordnung von zwei Gleichrichtermodulen und drei Wechselrichtermodulen in einem Bodenstromaggregat;
- Fig. 5: eine schematische Darstellung eines Gleichrichtermoduls und eines Wechselrichtermoduls.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

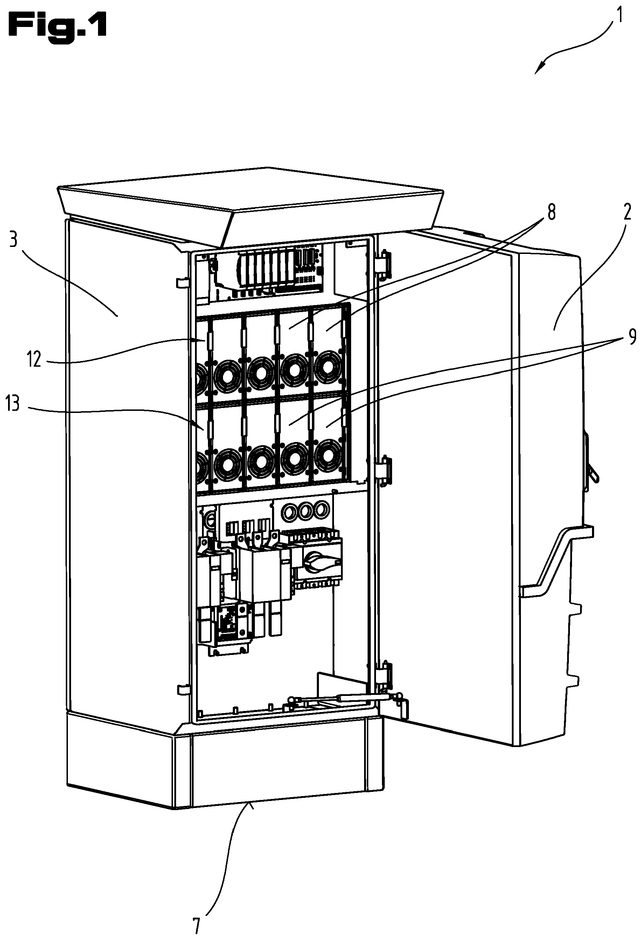

Nachfolgend wird das Bodenstromaggregat 1 bzw. dessen Bauteile und Funktionen anhand einer Zusammenschau der Figuren 1 bis 5 beschrieben.

Die Figur 1 zeigt eine isometrische Ansicht einer möglichen Ausführungsform des Bodenstromaggregates 1 mit geöffneter Schutzabdeckung 2.

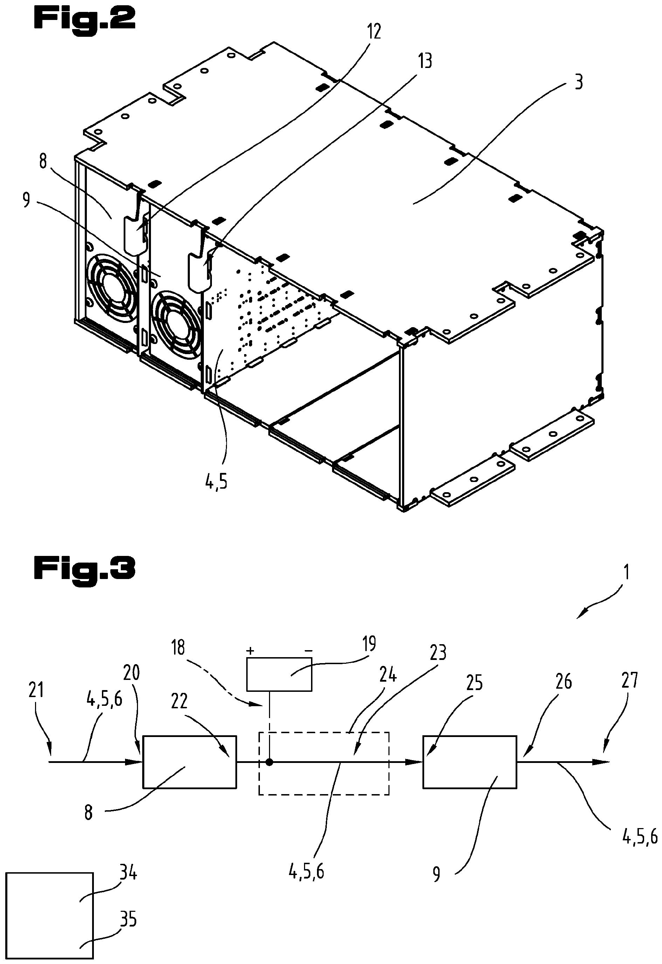

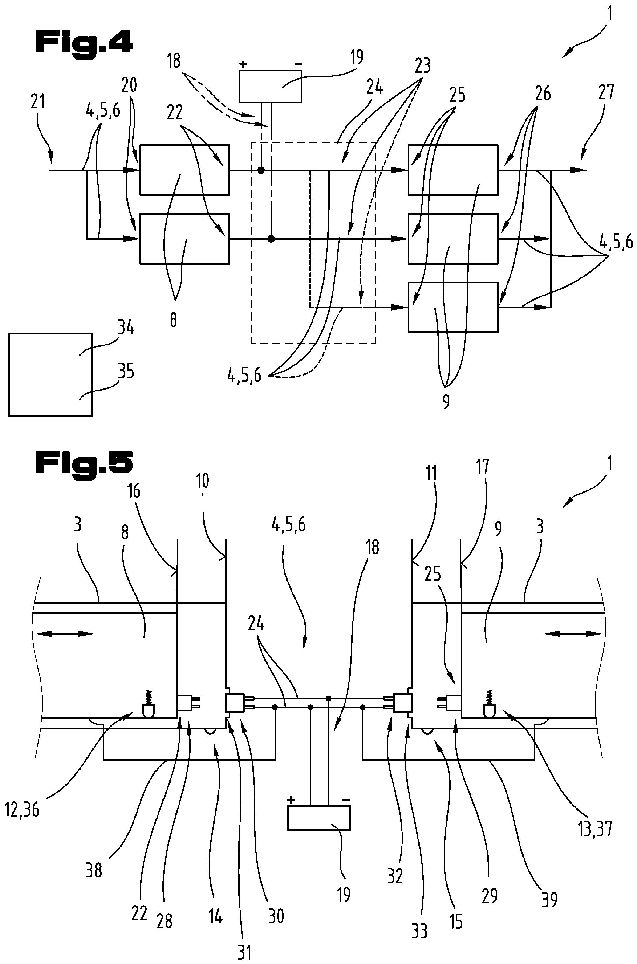

Das Bodenstromaggregat 1 umfasst ein Grundgestell 3 und ein in dem Grundgestell 3 ausgebildetes Kabelsystem 4. Dieses Kabelsystem 4 kann dabei elektrische Verbindungen in Form von Leiterplatten 5 und/oder Kabelbäumen 6 umfassen. Es sei darauf hingewiesen, dass das Kabelsystem 4, die Leiterplatten 5 und die Kabelbäume 6 schematisch in den Figuren 3 und 4 dargestellt sind.

Auf einer für einen Benutzer ergonomischen Arbeitshöhe, welche sich vorteilhaft bezogen auf eine Bodenaufstandsfläche 7 in einer Höhe von 0,5 m bis 2,0 m, besonders bevorzugt auf einer Höhe von 0,6 - 1,8 m, befindet, sind im Ausführungsbeispiel nach Figur 1 jeweils fünf Gleichrichtermodule 8 und fünf Wechselrichtermodule 9 angeordnet. Wie aus Figur 1 ersichtlich, kann vorgesehen sein, dass mehrere der Gleichrichtermodule 8 in horizontaler Richtung nebeneinander angeordnet sind, bzw. dass mehrere der Wechselrichtermodule 9 in horizontaler Richtung nebeneinander angeordnet sind. Weiters kann auch vorgesehen sein, dass die Gleichrichtermodule 8 und die Wechselrichtermodule 9 in vertikaler Richtung übereinander angeordnet sind.

In einer nicht dargestellten, alternativen Ausführungsvariante kann natürlich auch vorgesehen sein, dass in einer Ebene mehrere Gleichrichtermodule 8 und Wechselrichtermodule 9 nebeneinander angeordnet sind.

Dies vereinfacht das Auswechseln der Module 8, 9 und verbessert zudem die Luftführung zur Kühlung.

Die Gleichrichtermodule 8 und Wechselrichtermodule 9 sind dabei jeweils als baulich eigenständig ausgebildete Einheiten realisiert. Diese Einheiten sind einzeln und unabhängig voneinander vom Grundgestell 3 wechselbar. Die Gleichrichtermodule 8 und Wechselrichtermodule 9 sind in Figur 1 in einer Betriebsposition 10, 11 befindlich abgebildet, wobei die Lage der Betriebsposition 10, 11 insbesondere in der Figur 5 im Detail ersichtlich ist. Weiters kann vorgesehen sein, dass die Gleichrichtermodule 8 und Wechselrichtermodule 9 baugleich ausgeführt sind und in elektrischer Flussrichtung gesehen gespiegelt mit dem nicht abgebildeten Kabelsystem 4 gekoppelt sind.

In der Figur 1 dargestellt sind zudem Teile eines Schnellverschlusses 12, 13, welche an den Gleichrichtermodulen 8 und Wechselrichtermodulen 9 angeordnet sind.

Die Figur 2 zeigt eine isometrische Ansicht zweier Gleichrichtermodule 8 und/oder Wechselrichtermodule 9, angeordnet in einem Abschnitt des Grundgestells 3. Hierbei werden für gleiche Teile gleiche Bezugszeichen bzw. Bauteilbezeichnungen wie in der vorangegangenen Figur 1 verwendet. Um unnötige Wiederholungen zu vermeiden, wird somit auf die detaillierte Beschreibung in der vorangegangenen Figur 1 hingewiesen bzw. Bezug genommen.

Im dargestellten Ausführungsbeispiel ist ein Gleichrichtermodul 8 neben einem Wechselrichtermodul 9 angeordnet, es ist jedoch auch jede andere Anordnungsvariante möglich. Beispielsweise kann vorgesehen sein, dass mehrere der Gleichrichtermodule 8 in horizontaler Richtung nebeneinander angeordnet sind, bzw. dass mehrere der Wechselrichtermodule 9 in horizontaler Richtung nebeneinander angeordnet sind. Weiters kann auch vorgesehen sein, dass die Gleichrichtermodule 8 und die Wechselrichtermodule 9 in vertikaler Richtung übereinander angeordnet sind.

In einer nicht dargestellten, alternativen Ausführungsvariante kann natürlich auch vorgesehen sein, dass in einer Ebene mehrere Gleichrichtermodule 8 und Wechselrichtermodule 9 nebeneinander angeordnet sind.

Vorteilhafterweise sind die Gleichrichtermodule 8 und Wechselrichtermodule 9 auf Leiterplatten 5 aus Halbleitern aufgebaut, wobei die Halbleiter Siliziumkarbid umfassen.

In dem in Figur 2 dargestellten Abschnitt des Grundgestells 3 ist es möglich, bis zu fünf Gleichrichtermodule 8 und/oder Wechselrichtermodule 9 vorzusehen.

An den Gleichrichtermodulen 8 und Wechselrichtermodulen 9 kann zudem der Schnellverschluss 12, 13 realisiert sein, welcher derart konfiguriert ist, dass dieser beim Überführen in die Betriebsposition 10, 11 im Grundgestell 3 einrastet und/oder automatisch verriegelt.

Die Gleichrichtermodule 8 und Wechselrichtermodule 9 können jeweils auf nur einer Leiterplatte 5 aufgebaut sein.

In den Figuren 3 und 4 dargestellt sind jeweils ein Blockschema unterschiedlicher denkbarerer Anordnungen von Gleichrichtermodulen 8 und Wechselrichtermodulen 9 in einem Bodenstromaggregat 1.

Die Figur 3 zeigt insbesondere ein erstes Blockschema einer möglichen Anordnung von je einem Gleichrichtermodul 8 und je einem Wechselrichtermodul 9 in einem Bodenstromaggregat 1.

In der Figur 3 wird gezeigt, dass eine Eingangswechselspannung 21 an der Gleichrichtermoduleingangsseite 20 des Gleichrichtermodules 8 anliegt. Im dem Gleichrichtermodul 8 wird die Eingangswechselspannung 21 in eine Zwischengleichspannung 23 umgewandelt. Eine Gleichrichtermodulausgangsseite 22 des Gleichrichtermodules 8 ist mit einem Zwischenkreisleiter 24 gekoppelt, in den die Zwischengleichspannung 23 eingeleitet wird.

Das dargestellte Wechselrichtermodul 9 dient der Umwandlung der Zwischengleichspannung 23 in eine Ausgangswechselspannung 27. Hierbei liegt die Zwischengleichspannung 23 an der Wechselrichtermoduleingangsseite 25 an. Die Ausgangswechselspannung 27 verlässt die Wechselrichtermodule 9 an der Wechselrichtermodulausgangsseite 26.

Der Zwischenkreisleiter 24 ist bedarfsweise mit einem Paralleleingang 18 koppelbar, mittels welchem zusätzliche Gleichstromenergiequellen 19, wie etwa Batterien oder Akkus, in den Zwischenkreisleiter 24 einbindbar sind.

Die Figur 4 zeigt ein zweites Blockschema einer weiteren möglichen Anordnung von zwei Gleichrichtermodulen 8 und drei Wechselrichtermodulen 9 in einem Bodenstromaggregat 1.

Es ist jedoch selbstverständlich auch möglich, dass eine andere Anzahl an Gleichrichtermodulen 8 und/oder Wechselrichtermodulen 9 vorgesehen ist. Insbesondere kann vorgesehen sein, dass die Anzahl an Gleichrichtermodulen 8 und die Anzahl an Wechselrichtermodulen 9 im Bodenstromaggregat 1 gleich groß ist.

In der Figur 4 wird gezeigt, dass die Eingangswechselspannung 21 an den Gleichrichtermoduleingangsseiten 20 der zwei Gleichrichtermodule 8 anliegt. In den Gleichrichtermodulen 8 wird die Eingangswechselspannung 21 in die Zwischengleichspannung 23 umgewandelt. Die zwei Gleichrichtermodulausgangsseiten 22 der Gleichrichtermodule 8 sind mit dem Zwischenkreisleiter 24 gekoppelt, in den die Zwischengleichspannung 23 eingeleitet wird.

Die drei dargestellten Wechselrichtermodule 9 dienen der Umwandlung der Zwischengleichspannung 23 in die Ausgangswechselspannung 27. Hierbei liegt die Zwischengleichspannung 23 an den Wechselrichtermoduleingangsseiten 25 an. Die Ausgangswechselspannung 27 verlässt die Wechselrichtermodule 9 an den Wechselrichtermodulausgangsseiten 26.

Wie schon in der Figur 3 erläutert, kann der Zwischenkreisleiter 24 bedarfsweise mit einem Paralleleingang 18 koppelbar sein, mittels welchem zusätzliche Gleichstromenergiequellen 19, wie etwa Batterien oder Akkus, in den Zwischenkreisleiter 24 einbindbar sind.

Im vorliegenden Ausführungsbeispiel der Figur 4 sind die beiden dargestellten Gleichrichtermodule 8 elektrisch parallel zueinander geschalten. Gleiches gilt für die drei Wechselrichtermodule 9, welche ebenfalls elektrisch parallel zueinander geschalten sein können.

Aus der Figur 4 ist des Weiteren ersichtlich, dass ein Lastaufteilungssystem 35 derart konfiguriert sein kann, dass eine Lastaufteilung zwischen den Gleichrichtermodulen 8 und/oder zwischen den Wechselrichtermodulen 9 automatisiert erfolgen kann. Die Lastaufteilung zwischen den Gleichrichtermodulen 8 bzw. zwischen den Wechselrichtermodulen 9 kann dabei über einen Zentralrechner 34 erfolgen.

Im Teillastbereich sind einzelne Gleichrichtermodule 8 bzw. Wechselrichtermodule 9 wegschaltbar. Dies kann bevorzugt über den Zentralrechner 34 erfolgen.

Es kann zweckmäßig sein, wenn die Gleichrichtermodule 8 und Wechselrichtermodule 9 mit dem Zentralrechner 34 gekoppelt sind. Dieser Zentralrechner 34 kann ein oder auch mehrere defekte Gleichrichtermodule 8 oder ein oder mehrerer defekte Wechselrichtermodule 9 erkennen und kann diese in weiterer Folge automatisch wegschalten. Die Lastverteilung kann nach dem Wegschalten vom Lastaufteilungssystem 35 auf die restlichen Gleichrichtermodule 8 bzw. Wechselrichtermodule 9 anpasst werden.

Die Funktion der automatischen Lastverteilung bei Betrieb im Teillastbereich oder im Falle defekter Gleichrichtermodule 8 oder defekter Wechselrichtermodule 9 ist in der Figur 4 mittels strichlierter Linie dargestellt.

Die Gleichrichtermodule 8 und Wechselrichtermodule 9 weisen jeweils Datenschnittstellen auf, welche zum Informationsaustausch untereinander, sowie mit dem Zentralrechner 34 ausgebildet sind. Bei den Datenschnittstellen handelt es sich um digitale Datenschnittstellen. Jedem Gleichrichtermodul 8 und Wechselrichtermodul 9 ist dabei jeweils eine Adresse zugeordnet.

Figur 5 zeigt eine schematische Darstellung eines Gleichrichtermoduls 8 und eines Wechselrichtermoduls 9. Der linke Teil der Skizze zeigt eine stark vereinfachte Abbildung des Gleichrichtermoduls 8 in einer ersten Wechselposition 16. Dieses Gleichrichtermodul 8 kann auf seiner Gleichrichtermodulausgangsseite 22 einen ersten Stecker 28 aufweisen. Zudem kann das Gleichrichtermodul 8 an seiner Unterseite mit einem ersten Schnellverschluss 12 ausgestattet sein. Dieser erste Schnellverschluss 12 kann jedoch auch an anderen bzw. mehreren Stellen am Gleichrichtermodul 8 angeordnet sein.

Im Grundgestell 3 kann ein erster, mit einem mit dem Kabelsystem 4 elektrisch leitend verbundener erster Gegenstecker 30, sowie ein erstes Schnellverschlussaufnahmeelement 14 ausgebildet sein. Der erste Gegenstecker 30 ist dabei beispielsweise im Bereich einer ersten Aufnahmeaussparung 31 am Grundgestell 3 angeordnet. Beim Bewegen des Gleichrichtermoduls 8 von der ersten Wechselposition 16 in die erste Betriebsposition 10 kann es zu einem automatischen Einrasten des ersten Schnellverschlusses 12 im ersten Schnellverschlussaufnahmeelement 14 kommen. Das Einrasten wird in der dargestellten Skizze mithilfe eines ersten Federelements 36 im ersten Schnellverschluss 12 bewirkt, es sind jedoch auch andere Mechanismen denkbar. Beispielsweise kann das Verriegeln über das Umlegen eines Hebels erfolgen, wobei dieses Umlegen bevorzugt ohne den Einsatz von Werkzeugen erfolgen kann.

Durch das Überführen des Gleichrichtermoduls 8 in die erste Betriebsposition 10 werden können zudem der erste Stecker 28 und der erste Gegenstecker 30 automatisch elektrisch leitend verbunden werden.

Der erste Gegenstecker 30 kann über ein Kabelsystem 4 in Form einer Leiterplatte 5 oder auch in Form eines Kabelbaumes 6 mit einem Zwischenkreisleiter 24 gekoppelt werden. Dieser Zwischenkreisleiter 24 kann wiederum mit einem zweiten Gegenstecker 32 verbunden sein, wobei dieser zweite Gegenstecker 32 in einer zweiten Aufnahmeaussparung 33 positioniert sein kann.

Der weitere Aufbau ist bevorzugter Weise grundsätzlich baugleich mit dem zuvor beschriebenen Gleichrichtermodul 8. Der zweite Gegenstecker 32 kann beim Herstellen der zweiten Betriebsposition 11 mit einem zweiten Stecker 29 elektrisch leitend verbunden werden, indem das Wechselrichtermodul 9 aus einer zweiten Wechselposition 17 in diese zweite Betriebsposition 11 bewegt wird. Dieser zweite Stecker 29 kann dabei an der Wechselrichtermoduleingangsseite 25 des Wechselrichtermoduls 9 vorgesehen sein. Ident zum Gleichrichtermodul 8 weist das Wechselrichtermodul 9 infolge seiner gleichen Bauform einen zweiten Schnellverschluss 13 auf. Des Weiteren ist am Grundgestell 3 ein zweites Schnellverschlussaufnahmeelement 15 vorgesehen. Beim Bewegen des Gleichrichtermoduls 8 von der zweiten Wechselposition 17 in die zweite Betriebsposition 11 kann es zu einem automatischen Einrasten des zweiten Schnellverschlusses 13 im zweiten Schnellverschlussaufnahmeelement 15 kommen. Das Einrasten wird in der dargestellten Skizze mithilfe eines zweiten Federelements 37 im zweiten Schnellverschluss 13 bewirkt, es sind jedoch auch hier andere Mechanismen denkbar. Durch das Überführen des Gleichrichtermoduls 8 in die zweite Betriebsposition 11 können zudem der zweite Stecker 29 und der zweite Gegenstecker 32 automatisch elektrisch leitend verbunden werden.

Des Weiteren ist es denkbar, dass sowohl das Gleichrichtermodul 8, als auch das Wechselrichtermodul 9 über den ersten bzw. zweiten Gegenstecker 30, 32 mit einer ersten und einer zweiten Entladevorrichtung 38, 39 versehen sind. Werden das Gleichrichtermodul 8 oder Wechselrichtermodul 9 von der Betriebsposition 10, 11 in die Wechselposition 16, 17 überführt, so wird die gespeicherte elektrische Energie automatisch entladen.

Die Gleichrichtermodule 8 können mit einem aktiven Leistungsfaktorkorrekturfilter ausgestattet sein. Insbesondere dienen die Gleichrichtermodule 8 und Wechselrichtermodule 9 dazu, eine dreiphasige Eingangswechselspannung 21 in eine dreiphasige Ausgangswechselspannung 27 umzuwandeln. Bevorzugt wird eine dreiphasige Eingangswechselspannung 21 von 3x400 V / 50 Hz,3x480 V / 60 Hz, 960 V / 50 Hz oder 690 V / 50 Hz in eine dreiphasige Ausgangswechselspannung 27 von 3x200 V / 400 Hz, oder in eine Ausgangsgleichspannung von 28 V DC oder 270 V DC umgewandelt.

Figur 5 zeigt des Weiteren auch, dass der Zwischenkreisleiter 24 mit einem Paralleleingang 18 gekoppelt sein kann, mittels welchem zusätzliche Gleichstromenergiequellen 19, wie etwa Batterien oder Akkus, einbindbar sind.

Zusätzlich kann es zweckmäßig sein, wenn die Gleichrichtermodule 8 und Wechselrichtermodule 9 Datenschnittstellen aufweisen, welche zum Informationsaustausch untereinander und/oder mit einem Zentralrechner 34 ausgebildet sind. Bei der Datenschnittstellen handelt es sich insbesondere um digitale Datenschnittstellen.

Die Ausführungsbeispiele zeigen mögliche Ausführungsvarianten, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

**Bezugszeichenaufstellung**

| | | | |
|---|---|---|---|
| 1 | Bodenstromaggregat | 29 | zweiter Stecker |
| 2 | Schutzabdeckung | 30 | erster Gegenstecker |
| 3 | Grundgestell | 31 | erste Aufnahmeaussparung |
| 4 | Kabelsystem | 32 | zweiter Gegenstecker |
| 5 | Leiterplatte | 33 | zweite Aufnahmeaussparung |
| 6 | Kabelbaum | 34 | Zentralrechner |
| 7 | Bodenaufstandsfläche | 35 | Lastaufteilungssystem |
| 8 | Gleichrichtermodul | 36 | erstes Federelement |
| 9 | Wechselrichtermodul | 37 | zweites Federelement |
| 10 | erste Betriebsposition | 38 | erste Entladevorrichtung |
| 11 | zweite Betriebsposition | 39 | zweite Entladevorrichtung |
| 12 | erster Schnellverschluss | | |
| 13 | zweiter Schnellverschluss | | |
| 14 | erstes Schnellverschlussaufnahmeelement | | |
| 15 | zweites Schnellverschlussaufnahmeelement | | |
| 16 | erste Wechselposition | | |
| 17 | zweite Wechselposition | | |
| 18 | Paralleleingang | | |
| 19 | Gleichstromenergiequelle | | |
| 20 | Gleichrichtermoduleingangsseite | | |
| 21 | Eingangswechselspannung | | |
| 22 | Gleichrichtermodulausgangsseite | | |
| 23 | Zwischengleichspannung | | |
| 24 | Zwischenkreisleiter | | |
| 25 | Wechselrichtermoduleingangsseite | | |
| 26 | Wechselrichtermodulausgangsseite | | |
| 27 | Ausgangswechselspannung | | |
| 28 | erster Stecker | | |

## Patentansprüche

1. Bodenstromaggregat (1) für das Bereitstellen von elektrischer Energie für Fluggeräte, das Bodenstromaggregat (1) umfassend:
- ein Grundgestell (3);
- ein Kabelsystem (4), welches im Grundgestell (3) ausgebildet ist;
- zumindest ein Gleichrichtermodul (8) zum Umwandeln einer an einer Gleichrichtermoduleingangsseite (20) anliegenden Eingangswechselspannung (21) in eine an einer Gleichrichtermodulausgangsseite (22) abgehende Zwischengleichspannung (23), wobei die Gleichrichtermodulausgangsseite (22) mit einem Zwischenkreisleiter (24) gekoppelt ist;
- zumindest ein Wechselrichtermodul (9) zum Umwandeln der an einer Wechselrichtermoduleingangsseite (25) anliegenden Zwischengleichspannung (23) in eine an einer Wechselrichtermodulausgangsseite (26) abgehende Ausgangswechselspannung (27), wobei die Wechselrichtermoduleingangsseite (25) mit einem Zwischenkreisleiter (24) gekoppelt ist;
**dadurch gekennzeichnet, dass** das Gleichrichtermodul (8) und das Wechselrichtermodul (9) jeweils als baulich eigenständig ausgebildete Einheiten realisiert sind, welche einzeln und unabhängig vom Grundgestell (3) wechselbar sind, und
dass zumindest zwei Gleichrichtermodule (8) ausgebildet sind, welche elektrisch parallel zueinander geschalten sind und/oder dass zumindest zwei Wechselrichtermodule (9) ausgebildet sind, welche elektrisch parallel zueinander geschalten sind, und
dass ein Lastaufteilungssystem (35) ausgebildet ist, welches derart konfiguriert ist, dass eine Lastaufteilung zwischen den Gleichrichtermodulen (8) und/oder zwischen den Wechselrichtermodulen (9) automatisiert erfolgen kann.

2. Bodenstromaggregat (1) nach Anspruch 1, **dadurch gekennzeichnet, dass** das Gleichrichtermodul (8) und das Wechselrichtermodul (9) baugleich ausgeführt sind, insbesondere, dass das Gleichrichtermodul (8) und das Wechselrichtermodul (9) in elektrischer Flussrichtung gesehen gespiegelt mit dem Kabelsystem (4) gekoppelt sind.

3. Bodenstromaggregat (1) nach einem der vorhergehenden Ansprüche, **dadurch gekennzeichnet, dass** das Gleichrichtermodul (8) und das Wechselrichtermodul (9) jeweils zumindest einen Stecker (28, 29) aufweisen, welcher jeweils mit einem mit dem Kabelsystem (4) elektrisch leitend verbundenen Gegenstecker (30, 32) gekoppelt ist.

4. Bodenstromaggregat (1) nach Anspruch 3, **dadurch gekennzeichnet, dass** der Stecker (28, 29) derart am Gleichrichtermodul (8) und/oder am Wechselrichtermodul (9) angeordnet ist und der Gegenstecker (30, 32) derart im Bereich einer Aufnahmeaussparung (31, 33) am Grundgestell (3) angeordnet sind, dass in einer Betriebsposition (10, 11) des Gleichrichtermoduls (8) und/oder des Wechselrichtermoduls (9) eine elektrisch leitende Verbindung zwischen dem Stecker (28, 29) und dem Gegenstecker (30, 32) hergestellt ist.

5. Bodenstromaggregat (1) nach einem der vorhergehenden Ansprüche **dadurch gekennzeichnet, dass** das Gleichrichtermodul (8) und das Wechselrichtermodul (9) einen Schnellverschluss (12, 13) aufweisen, welcher derart ausgebildet ist, dass dieser beim Überführen in die Betriebsposition (10, 11) in einem Schnellverschlussaufnahmeelement (14, 15) im Grundgestell (3) einrastet und/oder automatisch verriegelt.

6. Bodenstromaggregat (1) nach einem der vorhergehenden Ansprüche, **dadurch gekennzeichnet, dass** das Gleichrichtermodul (8) und das Wechselrichtermodul (9) auf einer Höhe von 0,5 m bis 2,0 m, besonders bevorzugt auf einer Höhe von 0,6 - 1,8 m, bezugnehmend auf eine Bodenaufstandsfläche (7) des Grundgestells (3) positioniert sind.

7. Bodenstromaggregat (1) nach einem der vorhergehenden Ansprüche, **dadurch gekennzeichnet, dass** das Gleichrichtermodul (8) und das Wechselrichtermodul (9) jeweils auf nur einer Leiterplatte (5) aufgebaut sind.

8. Bodenstromaggregat (1) nach einem der vorhergehenden Ansprüche, **dadurch gekennzeichnet, dass** zumindest eines von mehreren parallel zueinander geschalteten Gleichrichtermodulen (8) und/oder zumindest eines von mehreren parallel zueinander geschalteten Wechselrichtermodulen (9) im Teillastbereich wegschaltbar ist.

9. Bodenstromaggregat (1) nach einem der vorhergehenden Ansprüche, **dadurch gekennzeichnet, dass** das Gleichrichtermodul (8) und/oder das Wechselrichtermodul (9) eine Datenschnittstelle aufweisen, welche zum Informationsaustausch untereinander und/oder mit einem Zentralrechner (34) ausgebildet ist.

10. Bodenstromaggregat (1) nach Anspruch 9, **dadurch gekennzeichnet, dass** es sich bei der Datenschnittstelle um eine digitale Datenschnittstelle handelt, und dass dem Gleichrichtermodul (8) und dem Wechselrichtermodul (9) jeweils eine Adresse zugeordnet ist oder zugeordnet werden kann, wobei das zumindest eine Gleichrichtermodul (8) und das zumindest eine Wechselrichtermodul (9) die Adresse bevorzugt über den Stecker (28, 29) erhält.

11. Bodenstromaggregat (1) nach einem der vorhergehenden Ansprüche, **dadurch gekennzeichnet, dass** der Zwischenkreisleiter (24) mit einem Paralleleingang (18) gekoppelt ist, mittels welchem zusätzliche Gleichstromenergiequellen (19), wie etwa Batterien oder Ackus, in den Zwischenkreisleiter (24) einbindbar sind.

12. Bodenstromaggregat (1) nach Anspruch 4, **dadurch gekennzeichnet, dass** eine Entladevorrichtung (38, 39) ausgebildet und derart im Grundgestell (3) und/oder im Gleichrichtermodul (8) und/oder im Wechselrichtermodul (9) angeordnet ist, dass beim Überführen von der Betriebsposition (10, 11) in eine Wechselposition (16, 17) die im Gleichrichtermodul (8) und/oder die im Wechselrichtermodul (9) gespeicherte elektrische Energie automatisch entladen wird.

13. Verfahren zum Warten und Betreiben eines Bodenstromaggregates (1) für das Bereitstellen von elektrischer Energie für Fluggeräte, insbesondere eines Bodenstromaggregates (1) nach einem der vorhergehenden Ansprüche, das Bodenstromaggregat (1) umfassend:
- ein Grundgestell (3);
- ein Kabelsystem (4), welches im Grundgestell (3) ausgebildet ist;
- zumindest ein Gleichrichtermodul (8) zum Umwandeln einer an einer Gleichrichtermoduleingangsseite (20) anliegenden Eingangswechselspannung (21) in eine an einer Gleichrichtermodulausgangsseite (22) abgehende Zwischengleichspannung (23), wobei die Gleichrichtermodulausgangsseite (22) mit einem Zwischenkreisleiter (24) gekoppelt ist;
- zumindest ein Wechselrichtermodul (9) zum Umwandeln der an einer Wechselrichtermoduleingangsseite (25) anliegenden Zwischengleichspannung (23) in eine an einer Wechselrichtermodulausgangsseite (26) abgehende Ausgangswechselspannung (27), wobei die die Wechselrichtermoduleingangsseite (25) mit einem Zwischenkreisleiter (24) gekoppelt ist; **dadurch gekennzeichnet, dass** das Verfahren folgenden Verfahrensschritt umfasst:
Auswechseln des Gleichrichtermodules (8) und/oder des Wechselrichtermodules (9), wobei diese jeweils als baulich eigenständig ausgebildete Einheiten realisiert sind, welche einzeln und unabhängig vom Grundgestell (3) ausgewechselt werden, und
wobei das Gleichrichtermodul (8) und/oder das Wechselrichtermodul (9) mit einem Zentralrechner (34) gekoppelt ist, wobei der Zentralrechner (34) ein defektes Gleichrichtermodul (8) und/oder Wechselrichtermodul (9) wegschaltet und die Lastverteilung auf die restlichen Gleichrichtermodule (8) und/oder Wechselrichtermodule (9) anpasst.

14. Verfahren nach Anspruch 13, **dadurch gekennzeichnet, dass** zumindest eines von mehreren parallel zueinander geschalteten Gleichrichtermodulen (8) und/oder zumindest eines von mehreren parallel zueinander geschalteten Wechselrichtermodulen (9) im Teillastbereich weggeschalten wird.

## Claims

1. A ground power unit (1) for providing electrical energy for aircraft, the ground power unit (1) comprising:
- a base frame (3);
- a cable system (4), which is formed in the base frame (3);
- at least one rectifier module (8) for converting an input alternating voltage (21) applied to a rectifier module input side (20) into an intermediate direct voltage (23) output at a rectifier module output side (22), wherein the rectifier module output side (22) is coupled to an intermediate circuit conductor (24);
- at least one inverter module (9) for converting the intermediate direct voltage (23) applied to an inverter module input side (25) into an output alternating current (27) which is output at an inverter module output side (26), wherein the inverter module input side (25) is coupled to an intermediate circuit conductor (24);
**characterized in that** the rectifier module (8) and the inverter module (9) are each realized as units formed to be structurally independent, which can be replaced individually and independently of the base frame (3), and
that at least two rectifier modules (8) are formed, which are electrically connected in parallel with one another, and/or that at least two inverter modules (9) are formed, which are electrically connected in parallel with one another, and
that a load distribution system (35) is formed, which is configured such that a load distribution between the rectifier modules (8) and/or between the inverter modules (9) can be carried out in an automated manner.

2. The ground power unit (1) according to claim 1, **characterized in that** the rectifier module (8) and the inverter module (9) have the same structural design, in particular that the rectifier module (8) and the inverter module (9) are coupled to the cable system (4) in a mirrored manner as viewed in the direction of the electric flow.

3. The ground power unit (1) according to one of the preceding claims, **characterized in that** the rectifier module (8) and the inverter module (9) each have at least one plug (28, 29), each of which is coupled to a mating plug (30, 32) connected to the cable system (4) in an electrically conductive manner.

4. The ground power unit (1) according to claim 3, **characterized in that** the plug (28, 29) is arranged on the rectifier module (8) and/or on the inverter module (9), and the mating plug (30, 32) is arranged in the region of a receiving recess (31, 33) on the base frame (3), such that in an operating position (10, 11) of the rectifier module (8) and/or of the inverter module (9), an electrically conductive connection between the plug (28, 29) and the mating plug (30, 32) is established.

5. The ground power unit (1) according to one of the preceding claims, **characterized in that** the rectifier module (8) and the inverter module (9) have a quick-release connector (12, 13), which is designed such that it engages with a quick-release connector receiving element (14, 15) in the base frame (3) and/or locks automatically upon transfer into the operating position (10, 11).

6. The ground power unit (1) according to one of the preceding claims, **characterized in that** the rectifier module (8) and the inverter module (9) are positioned at a height of 0.5 m to 2.0 m, particularly preferably at a height of 0.6-1.8 m, with respect to a ground contact area (7) of the base frame (3).

7. The ground power unit (1) according to one of the preceding claims, **characterized in that** the rectifier module (8) and the inverter module (9) are each installed on just one circuit board (5).

8. The ground power unit (1) according to one of the preceding claims, **characterized in that** at least one of multiple rectifier modules (8) connected in parallel with one another and/or at least one of multiple inverter modules (9) connected in parallel with one another can be disconnected in the part-load operational range.

9. The ground power unit (1) according to one of the preceding claims, **characterized in that** the rectifier module (8) and/or the inverter module (9) have a data interface, which is configured for the exchange of information with each other and/or with a main computer (34).

10. The ground power unit (1) according to claim 9, **characterized in that** the data interface is a digital data interface, and that both the rectifier module (8) and the inverter module (9) are each assigned an address or can be assigned an address, wherein the at least one rectifier module (8) and the at least one inverter module (9) preferably receive the address via the plug (28, 29).

11. The ground power unit (1) according to one of the preceding claims, **characterized in that** the intermediate circuit conductor (24) is coupled to a parallel input (18), by means of which additional direct current power sources (19), such as batteries or accumulators, can be integrated into the intermediate circuit conductor (24).

12. The ground power unit (1) according to claim 4, **characterized in that** a discharging device (38, 39) is formed and arranged in the base frame (3) and/or in the rectifier module (8) and/or in the inverter module (9) such that, upon transfer from the operating position (10, 11) into a changing position (16, 17), the electrical energy stored in the rectifier module (8) and/or in the inverter module (9) is automatically discharged.

13. A method for maintaining and operating a ground power unit (1) for providing electrical energy for aircraft, in particular a ground power unit (1) according to one of the preceding claims, the ground power unit (1) comprising:
- a base frame (3);
- a cable system (4), which is formed in the base frame (3);
- at least one rectifier module (8) for converting an input alternating voltage (21) applied to a rectifier module input side (20) into an intermediate direct voltage (23) output at a rectifier module output side (22), wherein the rectifier module output side (22) is coupled to an intermediate circuit conductor (24);
- at least one inverter module (9) for converting the intermediate direct voltage (23) applied to an inverter module input side (25) into an output alternating current (27) which is output at an inverter module output side (26), wherein the inverter module input side (25) is coupled to an intermediate circuit conductor (24);
**characterized in that** the method comprises the following method step:
replacing of the rectifier module (8) and/or of the inverter module (9), wherein they are each realized as units formed to be structurally independent, which are replaced individually and independently of the base frame (3), and
wherein the rectifier module (8) and/or the inverter module (9) is coupled to a main computer (34), wherein the main computer (34) disconnects a defective rectifier module (8) and/or inverter module (9) and adjusts the load distribution to the remaining rectifier modules (8) and/or inverter modules (9).

14. The method according to claim 13, **characterized in that** at least one of multiple rectifier modules (8) connected in parallel with one another and/or at least one of multiple inverter modules (9) connected in parallel with one another is disconnected in the part-load operational range.

## Revendications

1. Agrégat de courant de fond (1) pour la mise à disposition d'énergie électrique pour des aéronefs, l'agrégat de courant de fond (1) comprenant :
- un châssis de base (3) ;
- un système de câbles (4), qui se trouve dans le châssis de base (3) ;
- au moins un module redresseur (8) pour la conversion d'une tension alternative d'entrée (21) appliquée à un côté d'entrée du module redresseur (20) en une tension continue intermédiaire (23) sortant au niveau d'un côté de sortie du module redresseur (22), dans lequel le côté de sortie du module redresseur (22) est couplé avec un conducteur de circuit intermédiaire (24) ;
- au moins un module onduleur (9) pour la conversion de la tension continue intermédiaire (23) appliquée à un côté d'entrée du module onduleur (25) en une tension alternative intermédiaire (27) sortant au niveau d'un côté de sortie du module onduleur (26), dans lequel le côté d'entrée du module onduleur (25) est couplé avec un conducteur de circuit intermédiaire (24) ;
**caractérisé en ce que** le module redresseur (8) et le module onduleur (9) sont réalisés chacun en tant qu'unités autonomes, qui peuvent être changées individuellement et indépendamment du châssis de base (3) et
au moins deux modules redresseurs (8) sont prévus, qui sont branchés électriquement de manière parallèle entre eux et/ou au moins deux modules onduleurs (9) sont prévus, qui sont branchés électriquement de manière parallèle entre eux et
un système de répartition de charge (35) est prévu, qui est configuré de sorte qu'une répartition de charge peut avoir lieu de manière automatisée entre les modules redresseurs (8) et/ou entre les modules onduleurs (9).

2. Agrégat de courant de fond (1) selon la revendication 1, **caractérisé en ce que** le module redresseur (8) et le module onduleur (9) sont conçus de manière identique, plus particulièrement **en ce que** le module redresseur (8) et le module onduleur (9) sont couplés, vus dans la direction du flux électrique, en miroir avec le système de câbles (4).

3. Agrégat de courant de fond (1) selon l'une des revendications précédentes, **caractérisé en ce que** le module redresseur (8) et le module onduleur (9) comprennent chacun au moins un connecteur (28, 29) qui est couplé respectivement avec un contre-connecteur (30, 32) raccordé électriquement avec le système de câbles (4).

4. Agrégat de courant de fond (1) selon la revendication 3, **caractérisé en ce que** le connecteur (28, 29) est disposé sur le module redresseur (8) et/ou sur le module onduleur (9) et le contre-connecteur (30, 32) est disposé au niveau d'un évidement de logement (31, 32) sur le châssis de base (3) de sorte que, dans une position de fonctionnement (10, 11) du module redresseur (8) et/ou du module onduleur (9), une liaison électro-conductrice est établie entre le connecteur (28, 29) et le contre-connecteur (30, 32).

5. Agrégat de courant de fond (1) selon l'une des revendications précédentes, **caractérisé en ce que** le module redresseur (8) et le module onduleur (9) présentent une fermeture rapide (12, 13) qui est conçue de sorte que celle-ci, lors du passage dans la position de fonctionnement (10, 11), s'encliquette et/ou se verrouille automatiquement dans un élément de logement de fermeture rapide (14, 15) dans le châssis de base (3).

6. Agrégat de courant de fond (1) selon l'une des revendications précédentes, **caractérisé en ce que** le module redresseur (8) et le module onduleur (9) sont positionnés à une hauteur de 0,5 m à 2,0 m, plus particulièrement de préférence à une hauteur de 0,6 - 1,8 m, par rapport à une surface de contact (7) du châssis de base (3).

7. Agrégat de courant de fond (1) selon l'une des revendications précédentes, **caractérisé en ce que** le module redresseur (8) et le module onduleur (9) sont montés chacun sur un circuit imprimé (5).

8. Agrégat de courant de fond (1) selon l'une des revendications précédentes, **caractérisé en ce qu'**au moins un des modules redresseurs (8) branchés parallèlement entre eux et/ou au moins un des modules onduleurs (9) branchés parallèlement entre eux peut être débranché lors d'un fonctionnement à charge partielle.

9. Agrégat de courant de fond (1) selon l'une des revendications précédentes, **caractérisé en ce que** le module redresseur (8) et/ou le module onduleur (9) comprennent une interface de données qui est conçue pour un échange d'informations entre eux et/ou avec un ordinateur central (34).

10. Agrégat de courant de fond (1) selon la revendication 9, **caractérisé en ce que** l'interface de données est une interface de données numérique et **en ce que**, au module redresseur (8) et au module onduleur (9) correspond ou peut correspondre respectivement une adresse, dans lequel l'au moins un module redresseur (8) et l'au moins un module onduleur (9) obtient l'adresse de préférence par l'intermédiaire du connecteur (28, 29).

11. Agrégat de courant de fond (1) selon l'une des revendications précédentes, **caractérisé en ce que** le conducteur de circuit intermédiaire (24) est couplé avec une entrée parallèle (18), au moyen duquel des sources de courant continu supplémentaires (19), comme des batteries ou des accumulateurs, peuvent être intégrées dans le conducteur de circuit intermédiaire (24).

12. Agrégat de courant de fond (1) selon la revendication 4, **caractérisé en ce qu'**un dispositif de décharge (38, 39) est prévu et disposé dans le châssis de base (3) et/ou dans le module redresseur (8) et/ou dans le module onduleur (9), de sorte que, lors d'un passage de la position de fonctionnement (10, 11) dans une position de changement (16, 17), l'énergie électrique stockée dans le module redresseur (8) et/ou dans le module onduleur (9) est automatiquement déchargée.

13. Procédé de maintenance et de fonctionnement d'un agrégat de courant de fond (1) pour la mise à disposition d'énergie électrique pour des aéronefs, plus particulièrement d'un agrégat de courant de fond (1) selon l'une des revendications précédentes, l'agrégat de courant de fond (1) comprenant :
- un châssis de base (3) ;
- un système de câbles (4), qui se trouve dans le châssis de base (3) ;
- au moins un module redresseur (8) pour la conversion d'une tension alternative d'entrée (21) appliquée à un côté d'entrée du module redresseur (20) en une tension continue intermédiaire (23) sortant au niveau d'un côté de sortie du module redresseur (22), dans lequel le côté de sortie du module redresseur (22) est couplé avec un conducteur de circuit intermédiaire (24) ;
- au moins un module onduleur (9) pour la conversion de la tension continue intermédiaire (23) appliquée à un côté d'entrée du module onduleur (25) en une tension alternative intermédiaire (27) sortant au niveau d'un côté de sortie du module onduleur (26), dans lequel le côté d'entrée du module onduleur (25) est couplé avec un conducteur de circuit intermédiaire (24) ;
**caractérisé en ce que** le procédé comprend l'étape de procédé suivante :
- changement du module redresseur (8) et/ou du module onduleur (9), dans lequel ceux-ci sont réalisés respectivement sous la forme d'unités autonomes, qui sont changées individuellement et indépendamment du châssis de base (3) et
dans lequel le module redresseur (8) et/ou le module onduleur (9) est couplé avec un ordinateur central (34), dans lequel l'ordinateur central (34) débranche un module redresseur (8) et/ou module onduleur (9) défectueux et adapte la répartition de charge aux modules redresseurs (8) et/ou modules onduleurs (9) restants.

14. Procédé selon la revendication 13, **caractérisé en ce qu'**au moins un parmi plusieurs modules redresseurs (8) branchés parallèlement entre eux et/ou au moins un parmi plusieurs modules onduleurs (9) branchés parallèlement entre eux sont débranchés lors d'un fonctionnement en charge partielle.
